# FASCICULE DE BREVET EUROPEEN

(11) **EP 0 580 504 B1**
(45) Date de publication et mention de la délivrance du brevet: **18.09.1996**
(21) Numéro de dépôt: 93401881.3
(22) Date de dépôt: 21.07.1993
(51) Int. Cl.: H05K 7/14

(54) **Support pour boitier d'équipement électrique d'aéronef**
Gehäuseträger für elektrische Ausrüstung in einem Flugzeug
Support for casing for aircraft electronics

(30) Priorité: 24.07.1992 FR 9209172
(43) Date de publication de la demande: 26.01.1994
(73) Titulaire: VIBRACHOC, F-91028 Evry Cédex (FR)
(72) Inventeur: Meunier, Bernard, F-91820 Boutigny sur Essonne (FR); Pavie, Denis, F-91610 Ballancourt sur Essonne (FR); Pompei, Michel, F-91700 Villiers sur Orge (FR)
(74) Mandataire: Fournier, Michel

(56) Documents cités:
- EP-A- 0 421 847
- US-A- 4 766 517

## Description

La présente invention concerne un support pour boîtier d'équipement électrique d'aéronef.

Les équipements électriques pour aéronefs sont placés dans des boîtiers de dimensions standardisées. Il existe plusieurs dimensions standards de boîtiers plus ou moins larges. Chaque boîtier constitue un élément modulaire amovible interchangeable qui est placé dans un support. Le support porte à l'avant des verrous venant se fixer sur des pattes de fixation du boîtier et l'arrière du boîtier comporte un connecteur électrique qui vient s'enficher dans un connecteur complémentaire fixé à l'arrière du support. Les supports sont eux-mêmes fixés côte à côte le long d'étagères.

La présente invention concerne un tel support. De tels supports, compte tenu de leur application dans l'aéronautique doivent être légers. Ils sont donc en tôle mince d'alliage d'aluminium. L'épaisseur classique est de 1,6 mm. Cependant, ces supports sont soumis à de fortes sollicitations mécaniques et doivent ainsi être robustes et avoir une bonne tenue à la fatigue. C'est ainsi que l'on est amené à renforcer certaines parties du support et, en particulier, la semelle du support, dans sa partie avant et arrière, là où il est fixé, par le moyen de vis, à l'étagère sur laquelle est fixé le support.

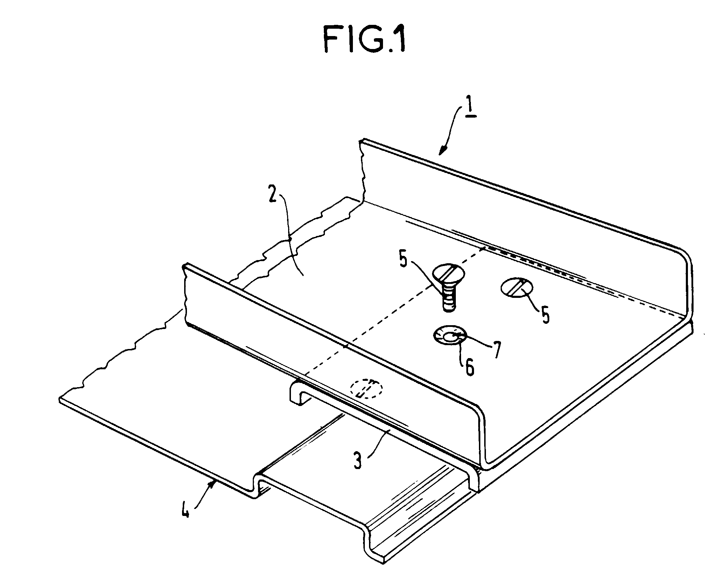

Comme le montre la figure 1 annexée, qui représente en perspective partielle la partie avant d'un support 1 d'un type connu, on voit que le fond ou la semelle 2 de cette partie avant de support en forme de U est renforcée à sa surface inférieure par une plaque de renfort 3. Cette plaque de renfort 3 est fixée à la semelle 2 du support par rivets et/ou points de soudure. Le support 1 est fixé sur son étagère 4 par des vis 5. Les têtes de vis ne devant évidemment pas dépasser, afin de permettre la mise en place du boîtier de l'équipement, celles-ci sont à têtes fraisées et donc logées dans une fraisure 6 effectuée à l'extrémité supérieure du trou 7 de passage de vis. Alternativement, il est également connu d'effectuer une cuvette de logement de tête de vis par emboutissage.

Cette disposition est satisfaisante pour accroître la raideur du support, mais ne l'est pas suffisamment pour la tenue en fatigue vibratoire, et l'on constate des fissures sur les bords des trous de passage des vis de fixation du support sur son étagère. En effet, comme on l'a dit plus haut, l'épaisseur de la tôle du support est faible et cette épaisseur est encore affaiblie au pourtour des trous de passage des vis de fixation par le fraisage pour le logement des têtes de vis et, dans le cas d'un logement de tête de vis par emboutissage, cette région est également plus fragile. Par ailleurs, la fixation de la plaque de renfort 3 sous la semelle 2 du support 1 n'est pas une liaison intime sur toute la surface du renfort mais, comme on l'a vu plus haut, une liaison par points de fixation (soudure et/ou rivets). Ainsi, dans les sollicitations transversales du support, la plaque de renfort 3, située sous la semelle 2, travaille beaucoup moins que la semelle située directement sous les têtes de vis. Cela aboutit donc, ainsi qu'on l'a dit, à des fissures des bords des trous de passage de vis dans la semelle 2.

La présente invention a pour but de pallier cet inconvénient et a pour objet un support pour boîtier d'équipement électrique d'aéronef destiné à être fixé sur une étagère, ledit support comportant une semelle, des bords latéraux et une face arrière, caractérisé en ce que au moins l'extrémité avant de ladite semelle de support est renforcée par une plaque de renfort fixée à la surface supérieure de ladite semelle et en ce que la partie de la semelle portant ladite plaque subit un décrochement de niveau vers le bas de façon à ce que la surface supérieure de ladite plaque soit au niveau de la surface de ladite semelle en arrière de ladite plaque de renfort, des trous de fixation étant prévus dans ladite plaque et semelle pour la fixation du support sur son étagère, par des vis dont les têtes sont logées dans des logements effectués dans ladite plaque de renfort.

Ainsi, dans cette disposition selon l'invention, c'est la plaque de renfort, qui travaille beaucoup moins que la semelle, qui reçoit directement les têtes de vis de fixation. En outre, et très avantageusement, cette plaque de renfort est plus épaisse que la semelle du support. Des essais de tenue en fatigue vibratoire ont ainsi montré que le résultat était excellent. On n'observe pas de fissures sur les bords des trous de fixation.

Comme dans l'art antérieur, la plaque de renfort est fixée à la semelle du support par des rivets et/ou des points de soudure.

L'invention va maintenant être décrite en se reportant au dessin annexé dans lequel :

La figure 1, déjà décrite, représente en vue partielle, en perspective, un support selon l'art antérieur.

La figure 2 montre en perspective un support selon une réalisation de l'invention.

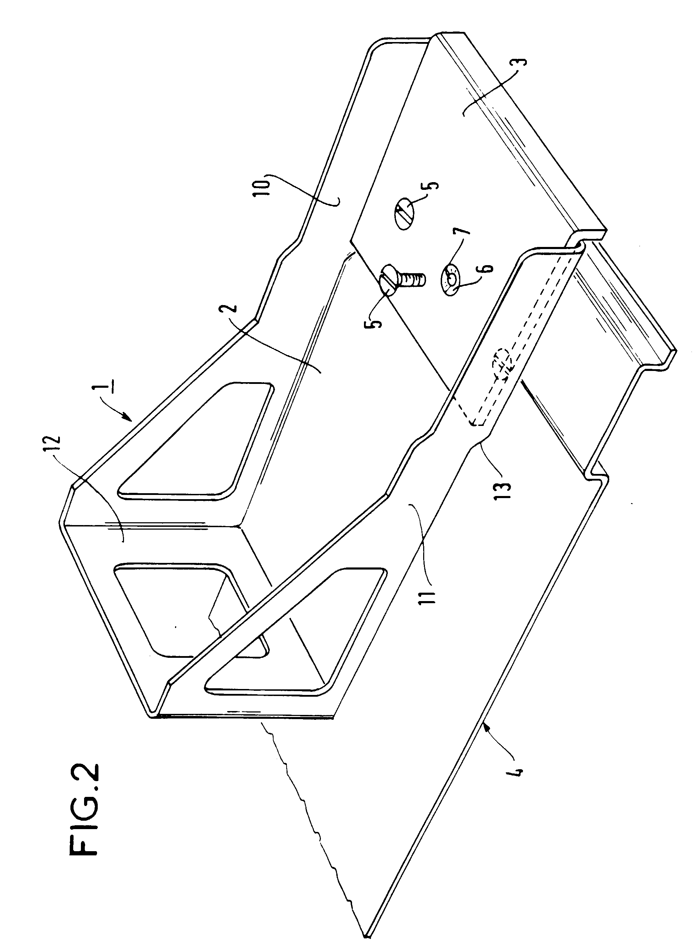

Ainsi, en se reportant à la figure 2, on voit un support 1 pour boîtier d'équipement électrique d'aéronef. Ce support comprend une semelle 2, des bords latéraux 10 et 11 et une face arrière 12. Ce support est destiné à être fixé sur une étagère 4.

Conformément à cette réalisation de l'invention, la partie avant de la semelle 2 du support 1 est renforcée par une plaque de renfort 3, mais qui est fixée sur, et non pas dessous, la semelle 2 du support 1. Elle est fixée de manière habituelle au moyen de rivets et/ou de points de soudure. Cette plaque de renfort 3 fait par exemple 2 mm d'épaisseur, tandis que l'épaisseur de la tôle, en alliage d'aluminium, du support 1 n'est que de 1,6 mm. Pour compenser la surépaisseur due à cette plaque de renfort 3, la semelle 1 comporte un décrochement 13 de niveau, vers le bas, correspondant à l'épaisseur de la plaque, de façon à ce que sa surface supérieure soit au niveau de la partie plus en arrière de la semelle 2 et ainsi permettre l'introduction du boîtier sans risque de heurt.

La fixation sur l'étagère 4 est effectuée par des vis 5 à têtes fraisées. La tête fraisée de chaque vis est logée dans un logement 6 réalisé par fraisage, ou emboutissage, autour de trous de passage 7, des vis de fixation, traversant la plaque 3 et la semelle 2.

## Revendications

1. Support (1) pour boîtier d'équipement électrique d'aéronef, destiné à être fixé sur une étagère (4), ledit support comportant une semelle (2), des bords latéraux (10, 11) et une face arrière (12), caractérisé en ce que au moins l'extrémité avant de ladite semelle (2) du support (1) est renforcée par une plaque de renfort (3) fixée à la surface supérieure de ladite semelle (2) et en ce que la partie de la semelle portant ladite plaque subit un décrochement (2) de niveau vers le bas de façon à ce que la surface supérieure de ladite plaque soit au niveau de la surface de ladite semelle en arrière de ladite plaque de renfort, des trous (7) de fixation étant prévus dans ladite plaque et semelle pour la fixation du support (1) sur son étagère (4), par des vis (5) dont les têtes sont logées dans des logements (6) effectués dans ladite plaque de renfort.

2. Support selon la revendication 1, caractérisé en ce que l'épaisseur de ladite plaque de renfort (3) est plus importante que celle de ladite semelle (2) du support.

## Patentansprüche

1. Träger (1) für das Gehäuse eines elektrischen Geräts in einem Luftfahrzeug, der an einem Regal (4) befestigt werden soll, wobei der Träger eine Bodenplatte (2), seitliche Ränder (10, 11) und eine Rückseite (12) aufweist, dadurch gekennzeichnet, daß zumindest das vordere Ende der Bodenplatte (2) des Trägers (1) durch eine Verstärkungsplatte (3) verstärkt ist, die an der Oberseite der Bodenplatte (2) befestigt ist, und daß der Teil der Bodenplatte, der diese Platte trägt, eine Niveauverschiebung (2) nach unten erfährt, so daß die Oberseite dieser Platte sich in Höhe der Oberseite der Bodenplatte an der Rückseite der Verstärkungsplatte befindet, wobei Befestigungslöcher (7) in dieser Platte und der Bodenplatte für die Befestigung des Trägers (1) auf seinem Regal (4) durch Schrauben (5) vorgesehen sind, deren Köpfe in Vertiefungen (6) in der Verstärkungsplatte versenkt sind.

2. Träger nach Anspruch 1, dadurch gekennzeichnet, daß die Dicke der Verstärkungsplatte (3) größer ist als die der Bodenplatte (2) des Trägers.

## Claims

1. Avionic tray (1) adapted to be fixed to a shelf (4) and comprising a base plate (2), side rails (10, 11) and a back plate (12), characterised in that at least the forward end of said base plate (2) of the tray (1) is reinforced by a reinforcing plate (3) fixed to the upper surface of said base plate (2), and in that the part of the base plate carrying said reinforcing plate is stepped downwards (13) so that the upper surface of said reinforcing plate is level with the surface of said base plate to the rear of said reinforcing plate, fixing holes (7) being provided in said reinforcing plate and said base plate for fixing the tray (1) to its shelf (4) by means of screws (5) whose heads are housed in housings (6) in said reinforcing plate.

2. Tray according to claim 1 characterised in that said reinforcing plate (3) is thicker than said base plate (2) of the tray.
